# EUROPEAN PATENT APPLICATION

(11) **EP 1 376 672 A1**
(43) Date of publication of application: **02.01.2004**
(21) Application number: 02705474.1
(22) Date of filing: 25.03.2002
(51) Int. Cl.: H01L 21/318

(54) **DEPOSITION METHOD, DEPOSITION APPARATUS, INSULATING FILM AND SEMICONDUCTOR INTEGRATED CIRCUIT**

(30) Priority: 28.03.2001 JP 2001094037; 04.07.2001 JP 2001203688
(71) Applicant: KABUSHIKI KAISHA WATANABE SHOKO, Chuo-ku, Tokyo 103-0022 (JP); Sugino, Takashi, Toyonaka-shi, Osaka 560-0085 (JP)
(72) Inventor: SUGINO, Takashi, Toyonaka-shi, Osaka 560-0085 (JP); KUSUHARA, Masaki, Kabushiki Kaisha Watanabe Shoko, Chuo-ku, Tokyo 103-0022 (JP); UMEDA, Masaru, Kabushiki Kaisha Watanabe Shoko, Chuo-ku, Tokyo 103-0022 (JP)
(74) Representative: Dr. Weitzel & Partner
(86) International application number: PCT/JP2002/002837
(87) International publication number: WO 2002/080260

(57) **Abstract**

To provide a method and an apparatus for forming a film capable of forming a boron-carbon-nitrogen film.

The method for forming the film comprises the steps of generating a plasma 50 in a cylindrical container 1, mainly exciting nitrogen atoms in the container 1, then reacting boron with carbon, and forming the boron-carbon-nitrogen film 61 on a substrate 60.

## Description

### BACKGROUND OF THE INVENTION

### Field of the Invention

The present invention relates to a method and an apparatus for forming a boron-carbon-nitrogen film, an insulating film, and a semiconductor integrated circuit.

### Related Art

Conventionally, in a semiconductor integrated circuit, films of SiO₂ or SiN formed by the Plasma CVD (Chemical Vapor Deposition) method have been used as an interlayer insulator thin films or a protective film for wiring. However, with higher integration of transistors, the inter-wiring capacitance causes wiring delay, and it has come into a problem as a factor of hindrance to speeding up switching operation of elements. In order to solve this problem, it is necessary to reduce the dielectric constant of the inter-wiring insulator thin film, and a material having a new dielectric constant is desired as the interlayer insulating film.

Under such a situation, organic materials and porous materials have attracted considerable attention and a very low dielectric constant (relative dielectric constant *k* is approximately 2.5 or less) can be realized, however, it has some problems from the view points of chemical and mechanical resistance and thermal conductivity.

Moreover, although such a very low dielectric constant value as 2.2 has been achieved recently with a boron-nitride thin film, it is known that the film has a problem in hydroscopic resistance.

Under the circumstances, a boron-carbon-nitrogen thin film which is excellent in thermal resistance, hydroscopic resistance and has a very low dielectric constant attracts considerable attention. However, the film forming technique by means of the Plasma CVD method has not been established yet at present, and it is desired to realize a film forming method permitting to form the boron-carbon-nitrogen thin film as a product.

The present invention has been made in view of the aforementioned situation, and the purpose of the invention is to provide the film forming method permitting to form a boron-carbon-nitrogen film and the film forming apparatus therefor.

### SUMMARY OF THE INVENTION

The film forming method of the present invention is comprised the steps of generating plasma in a deposition chamber, mainly exciting nitrogen atoms therein, then making the excited nitrogen atoms react with boron and carbon, and to form a boron-carbon-nitrogen film on a substrate.

The film forming method of the present invention is comprised the steps of generating plasma in the deposition chamber, mainly exciting nitrogen atoms therein, then making the excited nitrogen atoms react with boron chloride gas using hydrogen gas as a carrier gas, and to form the boron-carbon-nitrogen film on a substrate.

To supply carbon, it is preferable to use hydrocarbon gas. Using hydrocarbon has a new advantage of being able to simplify a gas supply system.

Moreover, it is also preferable to use an organic material for the supply of carbon. Using the organic material is characterized in that a part of boron and nitrogen can be supplied at the same time.

As an organic material, for example, an organic compound or the like containing trimethylboron or nitrogen is preferably used. Especially, trimethylboron is preferred.

A flow rate ratio of nitrogen gas to boron chloride gas is preferably set to 0.1 - 10.0. More preferably, it is 0.7 - 2.0, and it is further preferable to be 1.0 - 1.3.

A flow rate ratio of hydrocarbon gas to boron chloride gas is preferably set to 0.01 - 5.0. More preferably, it is 0.1 - 2.0, and it is further preferable to be 0.1-0.5.

A flow rate ratio of organic material gas to boron chloride gas is preferably set to 0.01 - 5.0. More preferably, it is 0.1 - 2.0, and it is further preferable to be 0.1 - 0.5.

The film forming apparatus of the present invention is comprised of a first introduction means for introducing nitrogen gas into the deposition chamber, a plasma generation means for generating plasma, a holding means for holding a substrate under or inside the plasma, and a second introduction means for introducing boron and carbon material between the first introduction means and the holding means.

The second introduction means is preferably constituted so as to be able to introduce boron and carbon independently of each other. Of course, the means may be constituted of single piping so that the mixture of boron and carbon is introduced without supplying them independently.

The film forming apparatus of the present invention is comprised of the first introduction means for introducing nitrogen gas into the deposition chamber, the plasma generation means for generating plasma, the holding means for holding the substrate under or inside the plasma, and the second introduction means for introducing boron chloride and hydrocarbon gases using hydrogen gas as a carrier gas into the deposition chamber under the first introduction means.

The film forming apparatus of the present invention is comprised of the first introduction means for introducing nitrogen gas into the deposition chamber, the plasma generation means for generating plasma, the holding means for holding the substrate under or inside the plasma, and the second introduction means for introducing boron chloride and organic material gases using hydrogen gas as a carrier gas into the deposition chamber under the first introduction means.

The aforementioned second introduction means is preferred to have a decomposition part on its halfway for decomposing the organic material, and it is preferred that this decomposition part is structured so as to be able to heat the organic material.

### BRIEF DESCRIPTION OF THE DRAWINGS

Fig.1 is a sectional view showing the film forming apparatus in accordance with the embodiment 1 of the present invention.
Fig.2 shows characteristic curves of a relative dielectric constant to a flow rate ratio of nitrogen gas to boron chloride gas.
Fig.3 shows characteristic curves of a relative dielectric constant to a flow rate ratio of methane gas to boron chloride gas.
Fig.4 is a sectional view showing the film forming apparatus in accordance with the embodiment 2 of the present invention.
Fig.5 is a sectional view showing the film forming apparatus in accordance with the embodiment 3 of the present invention.
Fig.6 is a sectional view showing the film forming apparatus in accordance with the embodiment 4 of the present invention.
Fig.7 is a schematic sectional view of the integrated circuit using the boron-nitride-carbon film formed by the film forming method relating to an embodiment of the present invention.
Fig.8 is a schematic sectional view of the integrated circuit using the boron-nitride-carbon film formed by the film forming method relating to an embodiment of the present invention.

### DETAILED DESCRIPTION OF THE PREFERRED EMBODIMENT

### (Embodiment 1)

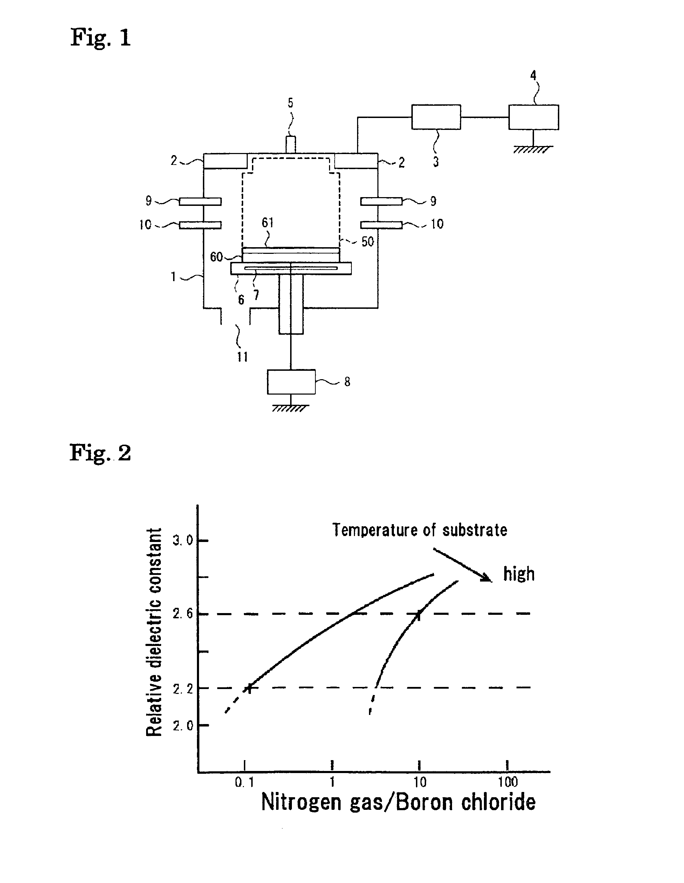

Fig.1 is a schematic side view showing the film forming apparatus for embodying the film forming method according to the first embodiment of the present invention. An inductively coupled plasma generation part 2 is provided in a cylindrical container 1, and is connected to a high-frequency power source 4 via a matching apparatus 3. The high-frequency power source 4 is able to supply high-frequency power of 1 kW - 10kW high-frequency power. Nitrogen gas is fed from a nitrogen gas introduction part 5, to generate plasma 50. A substrate 60 is placed on a substrate holding part 6, and a heater 7 is mounted in the substrate 60. The temperature of the substrate 60 can be set in the range from a room temperature up to 500degrees C by the heater 7. Moreover, a bias can be applied to the substrate 60 placed on the substrate holding part 6 by a bias applying part 8. The cylindrical container 1 is provided with an introduction part 9 for introducing boron chloride (boron trichloride) gas using hydrogen gas as a carrier. Moreover, the cylindrical container 1 is provided with an introduction part 10 for introducing hydrocarbon gas into the container 1. A gas exhaust part 11 is mounted under the substrate holding part 6.

As to a flow rate range of each gas supply, the system is arranged so as to be able to set the flow rate ratio of nitrogen gas to boron chloride to 0.1-10.0, the flow rate ratio of hydrocarbon gas to boron chloride to 0.01 - 5.0, and the flow rate ratio of hydrogen gas to boron chloride to 0.05 - 5.0.

A p-type silicon substrate 60 is placed on the substrate holding part 6, the inside of the container is vacuumed to 1 x 10⁻⁶ Torr. The substrate temperature is set to 300degrees C. Thereafter, nitrogen gas is introduced into the cylindrical container 1 through the introduction part 5. Plasma 50 is generated by supplying high-frequency electric power (13.56MHz) of 1 kw. Following this, boron chloride is transported into the container 1 with hydrogen gas as the carrier gas. In addition, methane gas is supplied into the container 1. Synthesis of a boron-nitride-carbon film 61 is performed in the container 1 whose gas pressure is adjusted to 0.6 Torr. The boron chloride and the methane gases are not made into plasma but are decomposed by nitrogen plasma to generate boron atoms and carbon atoms to be made to react with nitrogen atoms and to synthesize them into the boron-nitride-carbon film 61. Chlorine is combined with hydrogen atoms into hydrogen chloride, and thereby up-taking of the chlorine atoms into the film is controlled.

After having deposited a 100nm boron-nitride-carbon film 61 on the p-type silicon substrate 60 and vapor-deposited Au on the boron nitride carbon film 61 to form an electrode, a capacitance-voltage characteristic is measured. Then, the relative dielectric constants were evaluated by using the storage area capacitance value of a structure of metal, boron-nitride-carbon film, p-type silicon and the thickness of the boron-nitride-carbon film 61. As a result, low relative dielectric constant values of 2.2 - 2.6 were obtained.

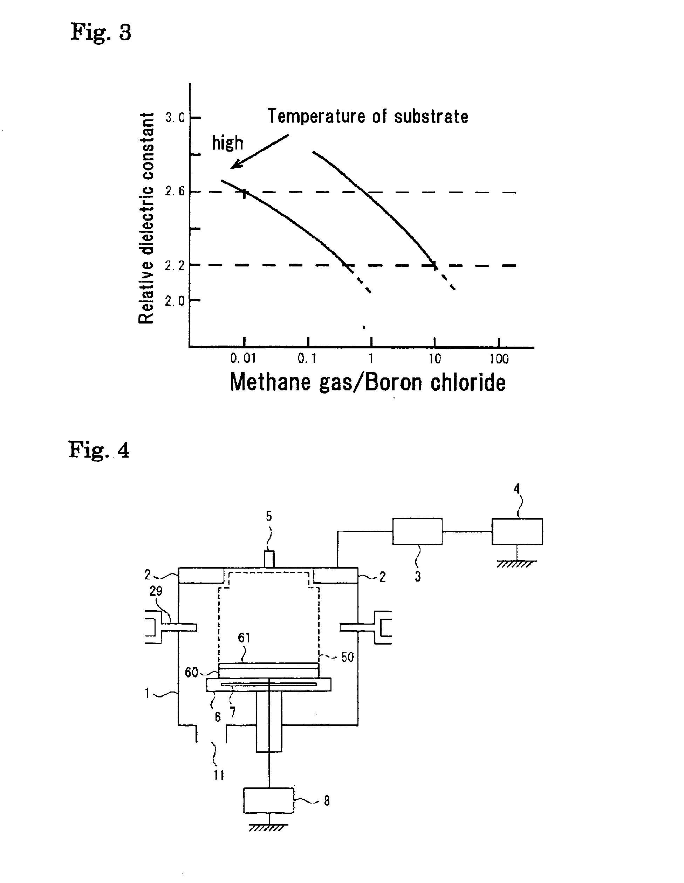

Fig.2 and Fig.3 show the synthesis conditions on which the boron-nitride-carbon film 61 having a dielectric constant as low as 2.2 - 2.6 can be obtained. Fig.2 shows a relationship between the flow rate ratios of nitrogen gas to boron chloride and the relative dielectric constants when a flow rate ratio of methane gas and boron chloride is made to 0.1. Fig.3 shows a relationship between a flow rate ratio of methane gas and boron chloride when a flow rate ratio of nitrogen gas to boron chloride is made to 1.3. The range of the gas flow rate ratios, in which the boron-nitride-carbon film 61 having the low relative dielectric constants can be obtained, can be made wider by varying the substrate temperature.

### (Embodiment 2)

Fig.4 is a schematic side view showing the film forming apparatus for embodying the film forming method according to the second embodiment of the present invention. An inductively coupled plasma generation part 2 is provided in a cylindrical container 1, and is connected to a high-frequency power source 4 via a matching apparatus 3. The high-frequency power source 4 is able to supply the high-frequency power of 1 kW - 10kW. Nitrogen gas is fed from a nitrogen gas introduction part 5, to generate plasma 50. A substrate 60 is placed on a substrate holding part 6, and a heater 7 is mounted in the substrate 60. The temperature of the substrate 60 can be set in the range from a room temperature up to 500 degrees C by the heater. Moreover, a bias can be applied to the substrate 60 placed on the substrate holding part 6 by a bias applying part 8. The cylindrical container 1 is provided with an introduction part 29. The introduction part 29 is provided so that boron chloride gas and hydrocarbon gas using hydrogen gas as the carrier gas are led just in front of the cylindrical container 1 without being mixed, then both lines are united at the introduction part into the cylindrical container 1 and both bases are introduced into the cylindrical container 1. A gas exhaust part 11 is arranged under the substrate holding part 6.

As to a flow rate range of each gas supply, the system is arranged so as to be able to set the flow rate ratio of nitrogen gas to boron chloride to 0.1-10.0, the flow rate ratio of hydrocarbon gas to boron chloride to 0.01 - 5.0, and the flow rate ratio of hydrogen gas to boron chloride to 0.05 - 5.0.

A p-type silicon substrate 60 is placed on the substrate holding part 6, and the inside of the container is vacuumed to 1 x 10⁻⁶ Torr. The substrate temperature is set to 300 degrees C. Thereafter, nitrogen gas is introduced into the cylindrical container 1 through the introduction part 5. Plasma 50 is generated by supplying high-frequency electric power (13.56MHz) of 1 kw. Following this, boron chloride is transported just in front of the container 1 with hydrogen gas as the carrier gas. Methane gas is also led just in front of the container 1 and boron chloride and methane gas are introduced in to the container 1 with the lines of both gases united. Synthesis of a boron-nitride-carbon film 61 is performed in the container 1 whose gas pressure adjusted to 0.6 Torr. The boron chloride and the methane gas are not excited into plasma but are decomposed by nitrogen plasma to produce boron atoms and carbon atoms to be made to react with nitrogen atoms and to synthesize them into the boron nitride carbon 61. Chlorine is combined with hydrogen atoms into hydrogen chloride, and thereby up-taking of the chlorine atoms into the film is controlled.

After having deposited the 100nm boron-nitride-carbon film 61 on the p-type silicon substrate 60 and vapor-deposited Au on the boron nitride carbon film 61 to form an electrode, a capacitance-voltage, characteristic is measured. Then the relative dielectric constants were evaluated by using the storage area capacitance value of a structure of metal, boron-nitride-carbon film, p-type silicon and the thickness of the boron-nitride-carbon film 61. As a result, low relative dielectric constant values of 2.2 - 2.6 were obtained.

In addition, in the method for introducing boron chloride and hydrocarbon gases according to this embodiment, a result similar to that of the embodiment 1 can be obtained.

### (Embodiment 3)

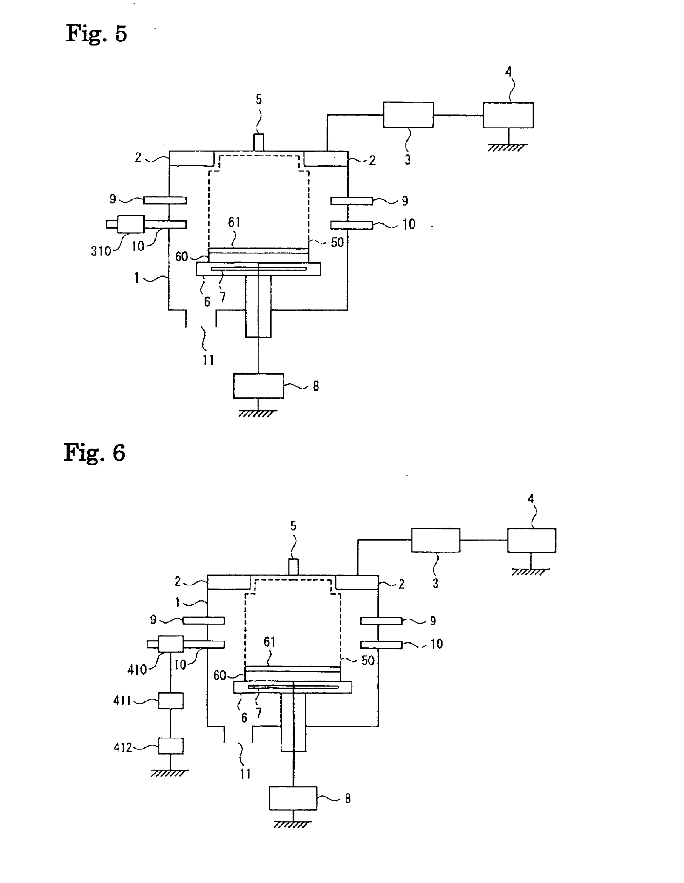

Fig.5 is a schematic side view showing the film forming apparatus for embodying the film forming method according to the third embodiment of the present invention. An inductively coupled plasma generation part 2 is provided in a cylindrical container 1, and is connected to a high-frequency power source 4 via a matching apparatus 3. The high-frequency power source 4 is able to supply the high-frequency power of 1 kW - 10kW. Nitrogen gas is fed from a nitrogen gas introduction part 5, to generate plasma 50. A substrate 60 is placed on a substrate holding part 6, and a heater 7 is mounted in the substrate 60. The temperature of the substrate 60 can be set in the range from a room temperature up to 500 degrees C by the heater. Moreover, a bias can be applied to the substrate 60 placed on the substrate holding part 6 by a bias applying part 8. The cylindrical container 1 is provided with the introduction part 9 for introducing boron chloride using hydrogen gas as the carrier. A decomposition part 310 for decomposing hydrocarbon gas is provided just in front of the cylindrical container 1 of the hydrocarbon gas introduction part 10. The gas exhaust part 11 is mounted under the substrate holding part 6.

As to a flow rate range of each gas supply, the apparatus is arranged so as to be able to set the flow rate ratio of nitrogen gas to boron chloride to 0.1-10.0, the flow rate ratio of hydrocarbon gas to boron chloride to 0.01 - 5.0, and the flow rate ratio of hydrogen gas to boron chloride to 0.05 - 5.0.

The p-type silicon substrate 60 is placed on the substrate holding part 6, and the inside of the container is vacuumed to 1 x 10⁻⁶ Torr. The substrate temperature is set to 300 degrees C. Thereafter, nitrogen gas is introduced into the cylindrical container 1 through the introduction part 5. Plasma 50 is generated by supplying high-frequency power (13.56MHz) of 1kw. Following this, boron chloride is transported into the container 1 with hydrogen gas as the carrier gas. In addition, methane gas is thermally decomposed at the decomposition part 310 mounted with a heater supplied into the container 1 through the introduction part 10. Synthesis of a boron-nitride-carbon film 61 is performed in the container 1 whose gas pressure is adjusted to 0.6 Torr. Carbon atoms are supplied by thermally decomposing the methane gas, and the boron chloride is not excited into plasma but is decomposed by nitrogen plasma, and the boron atoms and the carbon atoms obtained by the decomposition are made to react with nitrogen atoms to synthesize them into the boron nitride carbon 61. Chlorine is combined with hydrogen atoms into hydrogen chloride, and thereby up-taking of the chlorine atoms into the film is controlled.

After having deposited the 100nm boron-nitride-carbon film 61 on the p-type silicon substrate and vapor-deposited Au on the boron nitride carbon film 61 to form an electrode, a capacitance-voltage characteristic is measured. Then, the relative dielectric constants were evaluated by using the storage area capacitance value of a structure of metal, boron-nitride-carbon film, p-type silicon and the thickness of the boron-nitride-carbon film 61. As a result, low relative dielectric constant values of 2.2 - 2.6 were obtained.

In addition, in the embodiment 3, fabrication of the film having a characteristic similar to that of a low dielectric constant boron chloride carbon film obtained in the embodiment 1 and embodiment 2 can be achieved. Further, the embodiment 3 has the advantages of being able to achieve the low dielectric constant film under the condition that the flow rate of methane gas is decreased by about 20%, to improve an efficiency of up-taking carbon atoms into the deposition film, and to control amount of used methane gas.

### (Embodiment 4)

Fig.6 is a schematic side view showing the film forming apparatus for embodying the film forming method according to the fourth embodiment of the present invention. An inductively coupled plasma generation part 2 is arranged in a cylindrical container 1, and is connected to a high-frequency power source 4 via a matching apparatus 3. The high-frequency power source 4 is able to supply the high-frequency power of 1 kW - 10kW. Nitrogen gas is fed from a nitrogen gas introduction part 5, to generate plasma 50. A substrate 60 is placed on a substrate holding part 6, and a heater 7 is arranged in the substrate 60. The temperature of the substrate 60 can be set in the range from a room temperature up to 500 degrees C by the heater. Moreover, a bias can be applied to the substrate 60 placed on the substrate holding part 6 by a bias applying part 8. The cylindrical container 1 is provided with the introduction part 9 for introducing boron chloride using hydrogen gas as a carrier. A decomposition part 410 for decomposing hydrocarbon gas is arranged just in front of the cylindrical container 1 of the hydrocarbon gas introduction part 10. The gas exhaust part 11 is arranged under the substrate holding part 6.

As to a flow rate range of each gas supply, the apparatus is arranged so as to be able to set the flow rate ratio of nitrogen gas to boron chloride to 0.1-10.0, the flow rate ratio of hydrocarbon gas to boron chloride to 0.01 - 5.0, and the flow rate ratio of hydrogen gas to boron chloride to 0.05 - 5.0.

The p-type silicon substrate 60 is placed on the substrate holding part 6, and the inside of the container is vacuumed to 1 x 10⁻⁶ Torr. The substrate temperature is set to 300degrees C. Thereafter, nitrogen gas is introduced into the cylindrical container 1 through the introduction part 5. Plasma 50 is generated by supplying the high-frequency power (13.56MHz) of 1 kw. Following this, boron chloride is transported into the container 1 with hydrogen gas as the carrier gas. In addition, the decomposition part 410 mounted with a coil is supplied with the high-frequency power of 100W from a high-frequency power source 412 (13.56Mhz) through a matching apparatus 411, and the methane gas is decomposed by electric discharges and supplied into the container 1 from the introduction part 10. The gas pressure in the container 1 is adjusted to 0.6 Torr, to perform synthesis of a boron-nitride-carbon film 61. The boron chloride is not excited into plasma but decomposed by nitrogen plasma, to supply boron atoms. These boron atoms, carbon atoms supplied by the decomposition of methane gas, and nitrogen atoms are made to react with each other, to synthesize the boron-nitride-carbon film 61. The chlorine reacts with hydrogen atoms into hydrogen chloride, and up-taking chlorine atoms into the .film can be controlled.

After having deposited the 100nm boron-nitride-carbon film 61 on the p-type silicon substrate and vapor-deposited Au on the boron nitride carbon film 61 to form an electrode, a capacitance-voltage characteristic is measured. Then, the relative dielectric constants were evaluated by using the storage area capacitance value of a structure of metal, boron-nitride-carbon film, p-type silicon, and the thickness of the boron-nitride-carbon film 61. As a result, low relative dielectric constant values of 2.2 - 2.6 were obtained.

This embodiment 4 has demonstrated an effect similar to that of the embodiment 3, and has the advantages of being able to achieve the low dielectric constant film under the condition that the flow rate of methane gas is decreased by 25%, to improve an efficiency of up-taking carbon atoms into the deposition film, and to control amount of used methane gas.

In the embodiments 1 to 4, methane gas was used as the hydrocarbon gas, but various gases such as ethane gas, acetylene gas can be used.

### (Embodiment 5)

Using a film forming apparatus similar to the one as shown in Fig.1 used in the embodiment 1, trimethyl boron instead of methane gas is supplied into the cylindrical container 1 from the introduction part 10. The same conditions as applied to the embodiment 1 are used for the substrate temperature, high-frequency power, and the other synthesis conditions.

After having deposited the 100nm boron-nitride-carbon film 61 on the p-type silicon substrate and vapor-deposited Au on the boron nitride carbon film 61 to form an electrode, a capacitance-voltage characteristic is measured. Then, the relative dielectric constants were evaluated by using the storage area capacitance value of a structure of metal, boron-nitride-carbon film, p-type silicon, and the thickness of the boron-nitride-carbon film 61. As a result, low relative dielectric constant values of 2.2 - 2.6 were obtained.

Using the film forming apparatus similar to the ones as shown in Fig.4 - 6 used in the embodiments 2 to 4, trimethyl boron instead of methane gas is supplied into the cylindrical container 1 from the introduction part 10. The same conditions as applied to the embodiments 2 to 4 are used for the substrate temperature, high-frequency power, and the other synthesis conditions. Low relative dielectric constant values of 2.2 - 2.6 were obtained from the synthesized boron-nitride-carbon film 61.

In the embodiment 5, trimethyl boron was used as one of organic materials for supplying carbon atoms, however, any material can be used as long as it is an organic material containing boron or nitrogen atoms.

Moreover, although nitrogen gas was used to generate nitrogen plasma in the present embodiment, the same result can be obtained by using ammonia gas.

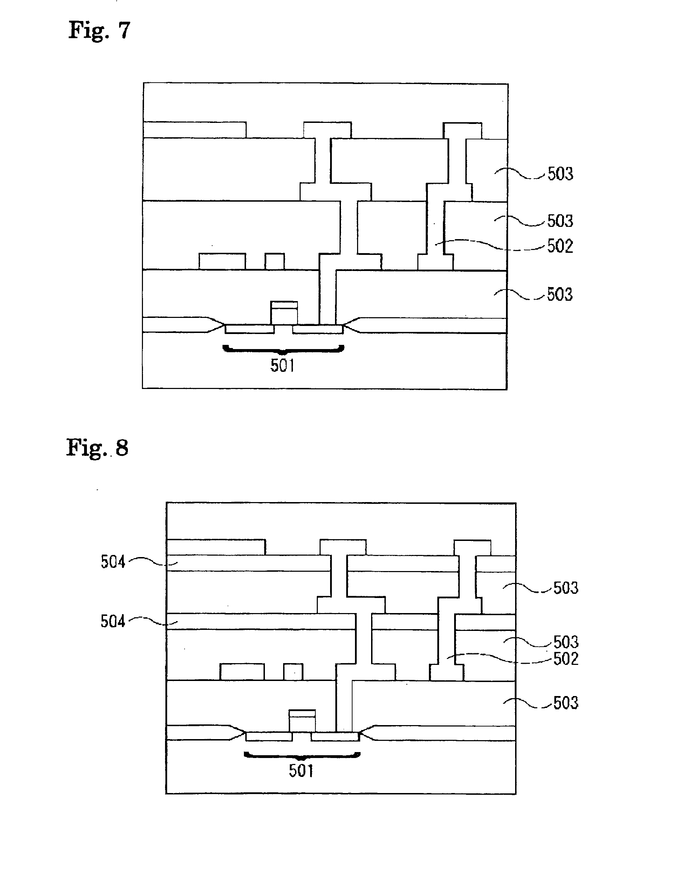

An application of the boron chloride carbon film formed by the film forming method of the present invention to an integrated circuit is explained referring to Fig.7. In order to make a wiring 502 to be of a multi-layer structure by highly integrating a transistor 501, it is necessary to use an interlayer insulator film 503 having a low dielectric constant between wiring, and the boron chloride carbon film formed by the present film forming method can be used.

Moreover, in the case that an organic thin film and a porous film are used as an interlayer insulator film 503, mechanical strength, hygroscopic property, and so on come into problems. However, as shown in Fig. 8, the boron chloride carbon films formed by the film forming method of the present invention can be used as protective films 504 for the organic thin films and porous films. A dielectric constant lower than that of a single layer of the boron chloride carbon film could be achieved by the coalescence of such organic thin film and porous film, and the boron chloride carbon film, and an effective relative dielectric constant as low as 1.9 could be obtained.

### Industrial Applicability

As explained above, according to the present invention, the plasma CVD method makes it possible to form boron-carbon-nitrogen films on a substrate for semiconductor integrated circuits and so on.

The film forming method of the present invention is comprising the steps of generating nitrogen plasma in a deposition container, supplying boron chloride using hydrogen as the carrier gas and a hydrocarbon or an organic material as a raw material source of carbon into the nitrogen plasma, and making them react with nitrogen so as to form the boron nitride carbon film. Therefore, the method permits to speedily form the boron-nitride-carbon film, which is chemically and mechanically stable, and has hygroscopic resistance, high thermal conductivity, and a low dielectric constant.

Moreover, the film forming apparatus of the present invention is provided with a nitrogen introduction means, a plasma generation means, a substrate holding means under the plasma generation means in a cylindrical container. Moreover, it is provided with means for introducing boron chloride as well as a hydrocarbon and an organic material as supply sources of carbon between the nitrogen introduction means and the substrate holding means, and makes boron and carbon atoms react with plasmatic nitrogen, to form the boron-nitride-carbon film. As a result, the mechanically and chemically stable boron-nitride-carbon film having hygroscopic resistance and high thermal conductivity can be formed speedily.

The boron-nitride-carbon film in accordance with the present invention can be used as an inter-wiring insulator thin film or a protective film.

### (Explanation of the References)

1... cylindrical container
2... Inductively Coupled Plasma generation part
3, 411... matching apparatus
4, 412... high-frequency power source
5... nitrogen gas introduction part
6... substrate holding part
7... heater
8... bias applying part
9, 10, 29... introduction part
11... gas exhaust part
50... plasma
60... substrate
61... boron-nitride-carbon film
310, 410... decomposition part
501... transistor
502... wiring
503... interlayer insulator film
504... protective film

## Claims

1. A film forming method comprising the steps of generating plasma in a deposition chamber, exciting mainly nitrogen atoms in the deposition chamber, thereafter, making the excited nitrogen atoms react with boron and carbon, and forming a boron-nitride-carbon film on a substrate.

2. A film forming method comprising the steps of generating plasma in a deposition chamber, exciting mainly nitrogen atoms in the deposition chamber, thereafter, making the excited nitrogen atoms react with boron chloride gas and carbon using hydrogen gas as a carrier, and thereby forming a boron-carbon-nitrogen film on a substrate.

3. The film forming method as claimed in claim 1 or 2, comprising the step of using hydrocarbon gas for supplying carbon.

4. The film forming method as claimed' in claim 1 or 2, comprising the step of using an organic material for supplying carbon.

5. The film forming method as claimed in any of the claims 2 to 4, comprising the step of setting a ratio of the nitrogen gas flow rate to the boron chloride gas flow rate gas to 0.1 - 10.0.

6. The film forming method as claimed in claim 3, comprising the step of setting a ratio of the hydrocarbon gas flow rate to the boron chloride gas flow rate to 0.01 - 5.0.

7. The film forming method as claimed in claim 4, comprising the step of setting a ratio of the organic series material gas flow rate to the boron chloride gas flow rate to 0.01 - 5.0.

8. A film forming apparatus comprising a first introduction means for introducing nitrogen gas into a deposition chamber, a plasma generation means for generating plasma, a holding means for holding a substrate under or inside the plasma, and a second introduction means for introducing boron and carbon material between the first introduction means and the holding means.

9. The film forming apparatus as claimed in claim 8, wherein said second introduction means is constituted so as to introduce boron and carbon independently of each other.

10. A film forming apparatus comprising a first introduction means for introducing nitrogen gas into a deposition chamber, the plasma generation means for generating plasma, a holding means for holding a substrate under or inside plasma, and a second introduction means for introducing boron chloride gas and hydrocarbon series gas using hydrogen gas as a carrier gas into the deposition chamber under the first introduction means.

11. A film forming apparatus comprising a first introduction means for introducing nitrogen gas into a deposition chamber, a plasma generation means for generating plasma, a holding means for holding a substrate under or inside the first introduction means, and a second introduction means for introducing boron chloride and an organic material gas using hydrogen gas as a carrier gas into the deposition chamber under the first introduction means.

12. The film forming apparatus as claimed in claim 11, wherein said second introduction means has on the way a decomposition part for decomposing the organic material.

13. The film forming apparatus as claimed in claim 12, wherein said decomposition part is arranged so as to be able to heat the organic material.

14. An insulating film formed by any of the methods as claimed in claim 1 to claim 7.

15. A semiconductor integrated circuit having the insulating film as claimed in claim 14.

16. The semiconductor integrated circuit as claimed in claim 15, wherein said insulating films are inter-wiring insulating films.
